# EUROPEAN PATENT SPECIFICATION

(11) **EP 4 560 047 B1**
(45) Date of publication and mention of the grant of the patent: **01.04.2026**
(21) Application number: 24214250.3
(22) Date of filing: 20.11.2024
(51) Int. Cl.: C23C 16/44, C23C 16/54, C30B 25/02, C30B 25/08, C30B 35/00, H01L 21/677, H01L 21/67

(54) **AUTOMATION SYSTEM FOR A REMOVABLE REACTION UNIT OF AN EPITAXIAL REACTOR**
AUTOMATISIERUNGSSYSTEM FÜR EINE ABNEHMBARE REAKTIONSEINHEIT EINES EPITAXIEREAKTORS
SYSTÈME D'AUTOMATISATION POUR UNE UNITÉ DE RÉACTION AMOVIBLE D'UN RÉACTEUR ÉPITAXIAL

(30) Priority: 21.11.2023 IT 202300024663; 21.11.2023 IT 202300024660
(43) Date of publication of application: 28.05.2025
(73) Proprietor: LPE S.p.A., 20021 Baranzate (MI) (IT)
(72) Inventor: MESCHIA, Maurilio, I-20021 Baranzate (Milano) (IT)
(74) Representative: Di Biase, Fabio

(56) References cited:
- US-A1- 2002 108 714
- US-A1- 2002 137 346
- US-A1- 2018 211 856

## Description

### FIELD OF INVENTION

The present invention relates to the field of automation, and specifically to an automated handling machine for the handling of removable reaction units for preventive maintenance operations, where said reaction units are used in reactors for the epitaxial deposition of semiconductor films on substrates.

The present invention further relates to a removable reaction unit of a reactor adapted to cooperate with the automated handling machines hereinbefore described and an assembly incorporating said machines.

### BACKGROUND OF THE DISCLOSURE

The epitaxial growth equipment for the semiconductor industry may comprise a reactor containing a reaction and deposition chamber where the chemical vapor deposition process occurs. As a result of the deposition process, several parts of the chamber will be subject to undesired product build-up and will require cleaning or substitution after reaching a certain thickness, to avoid affecting the quality and performance of the reaction and deposition process.

As a result, the consumable parts within the reaction chamber, as well as the walls and pieces composing the reaction chamber itself, necessitate preventive maintenance operations which entail periodically accessing the chamber for the removal, maintenance, or substitution of said parts and pieces.

These operations heavily impact on the downtime of the reactor and its throughput, and the issue is particularly felt in hot wall reactors for the deposition of SiC, where maintenance operations occur frequently, one or more times a week, and entail a stop of the reactor of several hours.

The above can be observed also with advantageous reactor designs used in the art, such as the ones described in EP1570107 and WO2021105841, chosen for their excellent heat distribution profiles and easy assemblage.

In these instances, the removal, clean-up, and substitution of the concerned parts of a reaction chamber is a time-consuming process mostly carried out by hand. Indeed, the substitution or cleaning of pieces requires an operator to access, from within the machine, individual parts located inside the reaction chamber.

Overall, the process requires a complete cooling of the reactor and reaction chamber, the undesired exposure to air of the latter, and the concurrent presence of an operator during all stages.

In the best-case scenario, where the reactor is of the removable type, it is possible to to pull out the reactor from the machine in its entirety via mechanical means. However, the process still presents the disadvantages described above: the access to the chamber is not automated or automatable, as it is still done by hand, the reactor is exposed to air, and its displacement (and handling) is cumbersome and requires manual intervention. Above all, the downtime is still disadvantageously long, as it takes at least eight hours for all necessary operations to be completed.

In some last generation reactors, the handling of substrate holders is performed in an automated fashion. Any additional automated system should therefore be suited to the limited space available in the machine and be adapted not to interfere with the automated means for handling substrate holders. US 2002/137346 Al discloses a system comprising (i) a plurality of removable processing chamber modules and (ii) a robot assembly for transferring one or more workpieces.

It is therefore desirable to automate the insertion and replacement processes of a reaction unit in a reactor; in particular, though not exclusively, for periodic preventive maintenance operations.

It is furthermore desirable to provide an automated handling machine and assembly suited to execute the automated handling of a removable reaction unit of a reaction chamber and to avoid its exposure to air. It is furthermore desirable to provide a removable reaction unit of a reaction chamber adapted to cooperate with said automated handling machine,

Additionally, it is desirable to provide an automated handling machine capable not to interfere with the automated handling of a substrate holder, if present.

### SUMMARY OF THE DISCLOSURE

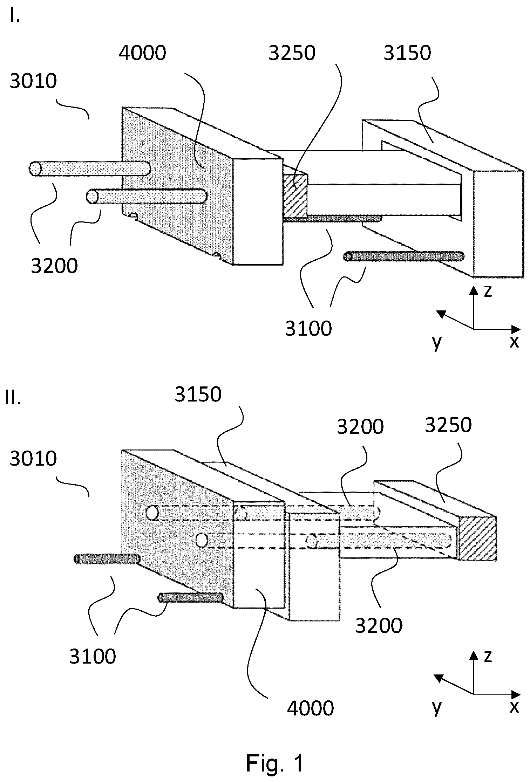

This application claims priority to IT App. 102023000024663, filed November 21, 2023, the entire contents of which are incorporated herein by reference. In particular, but not exclusively, incorporation by reference is made in regard to: claims 1-16, Figs. 1-3 and the corresponding sections of the description of IT App. 102023000024663.

This Application also claims priority to IT App. 102023000024660, filed November 21, 2023, the entire contents of which are incorporated herein by reference. In particular, but not exclusively, incorporation by reference is made in regard to: claims 1-22, Figs. 1-4 and the corresponding sections of the description of IT App. 102023000024660.

It is an object of the present invention to overcome the disadvantages of the prior art. More specifically, it is an object of the present invention to provide an automated handling machine suited to execute the handling of a removable reaction unit of a reaction chamber and to preferably avoid its exposure to air.

It is a further an object of the present invention to provide an automated handling machine capable to alternatively execute the automated handling of reaction unit and of a substrate holder.

It is an additional object of the present invention to provide a reaction chamber equipped with a removable reaction unit, wherein the latter is adapted to cooperate with the automated handling machine hereinbefore described and where the reaction chamber is suitable for the deposition of SiC, and GaN films on semiconductor substrates in a hot-wall, crossflow reactor.

It is a further object of the present invention to provide an assembly suitable to perform the automated handling of a reaction unit for preventive maintenance operations, with reduced downtimes.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

This summary is provided to introduce a selection of concepts in a simplified form. These concepts are further described in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE FIGURES

Fig. 1 provides a simplified sketch of the automated handling machine according to an embodiment of the present invention in two positions, respectively illustrated in panel I and II.
Fig. 2 provides a simplified sketch of a reaction chamber according to an embodiment of the present invention.
Fig. 3 provides a simplified sketch of an assembly according to an embodiment of the present invention.

It will be appreciated that elements in the figures are illustrated for simplicity and clarity and have not necessarily been drawn to scale. For example, the dimensions of some of the elements in the figures may have been omitted or, on the other hand, exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Epitaxial reactors of cylindrical shape, such as those described in EP 1570107 and US2022411961, have proven commercially successful thanks to the uniformity and efficiency of the heating of the reaction chamber, the simplicity of construction, and the quality of the deposited films. For SiC and GaN epitaxial film deposition they may operate at temperatures between 1000-1800 °C.

These cylindrical reactors typically extend rather uniformly along a longitudinal horizontal direction and exhibit an essentially circular cross section.

They comprise a reaction chamber, formed by one or more structural elements. Two of these structural elements may exhibit high susceptivity, for instance they can be made of graphite and exhibit a half-moon shape. They may be heated via induction means, such as one or more induction coils wrapped around the reactor. Other structural elements of the reaction chamber may be made of a same of a different material, such as SiC, to impart preferential current flows in the susceptive elements and expedite their induction heating. With the term susceptive, here and in the following, it is meant a material with high susceptivity that can be heated efficiently by induction.

The reaction chamber described in EP 1570107 and US2022411961 is formed via the assembly of the pieces above described. The assembly creates an inner space, of essentially parallelepiped shape, where the actual reaction takes place. This simple parallelepiped shape cannot be separated and moved in one piece from the constituting susceptive elements. Indeed, the chamber exhibits an overall complex profile of substantially circular cross section and intersecting lines, thereby making it difficult to handle.

Cylindrical reactors like the ones described in the above non limiting example, which is provided solely for illustrative purposes, require long down-times for preventive maintenance operations, which are rendered necessary due to the buildup of deposited material on the internal surfaces of the reaction chamber, including the surfaces of disposable or removable parts- such as, for instance, those used to rotate, support, and align the substrate, and/or to improve the fluid dynamics (directing the flow of carrier, precursor and exhaust gases) in the reaction chamber interior.

The inventors have devised an alternative reaction chamber design, where the reaction unit where the deposition takes place can be extracted in one piece and is adapted to cooperate with and automated handling machine.

According to this new design, the reaction chamber comprises:
(a) an essentially hollow susceptive casing, extending along a longitudinal direction (x) and featuring an internal surface and an external surface; and
(b) a removable reaction unit having an inner and outer surface and comprising four walls, connected or connectable to each other, and extending along to the longitudinal direction.

The reaction unit also features two open or partially open sides: an upstream and a downstream side. These sides are parallel to a transverse plane (yz) perpendicular to said longitudinal direction.

The removable reaction unit may have a box-like shape, with the four walls essentially parallel to the longitudinal direction. However, they may also slightly converge towards the upstream or downstream side. Their cross section in the transverse plane may present a straight profile or be curved or bent.

One of the four walls of the reaction unit is a bottom wall provided with a receiving area adapted to receive a substrate holder. The sides (upstream or downstream) can be open or feature an upstream and/or downstream wall.

In any case, the upstream side comprises an upstream aperture suited to receive a flow of carrier and precursor gases for the epitaxial deposition. Similarly, the downstream side comprises a downstream aperture suited to discharge a flow of exhaust gases. These apertures can take up the entire upstream/downstream sides or be holes traversing the corresponding upstream and/or downstream walls, if present.

The reaction unit according to the invention is mechanically connected to the susceptive casing via releasable coupling means, which can be used to support and/or fasten and/or align the reaction unit with/to the susceptive casing. The reaction unit and the releasable coupling means are adapted to withdraw or insert the reaction unit from or into the susceptive casing in one piece.

This allows to extract and replace the reaction unit in a simple manner, without having to reach its interiors from within the reactor machine or having to displace the entire reactor and the susceptive elements outside the machine to access its internal parts and pieces and expose them to air.

The susceptive casing is adapted to be heated by induction, and to this effect it can be advantageously made in graphite. The reaction unit is principally heated by the by susceptive casing through irradiation from the susceptive casing.

The susceptive casing may exhibit a hollow prismatic or cylindrical shape with a polygonal, circular, oval or elliptical cross-section in the transverse plane. An essentially circular cross section may allow an advantageously uniform heat distribution.

The susceptive casing may be advantageously open on one or both sides in the transverse plane (yz) to facilitate access to the reaction unit. The opening may be advantageously closed with insulating lids during operation.

To further tune the heat irradiation profile, the susceptive casing may exhibit a variable thickness either in the longitudinal direction and/or in the transverse plane (yz).

The four walls of the reaction unit may comprise a top wall and two lateral walls. Either the top wall or the bottom wall can be beneficially connected to the two lateral walls and to the upstream and downstream sides via releasable coupling means. This allows to easily access the internal parts of the chamber (the disposable graphite parts and/or the inner surfaces of the walls) for maintenance and/or replacement.

The releasable coupling means may be advantageously chosen among non-permanent mechanical interlocking or fastening mechanisms, such as hook and loop mechanisms, snap closures, or any other female-male fastening/joining means suitable to be quickly and easily released.

The internal surface of the susceptive casing can be provided with grooves or protrusions adapted to support, position, and/or releasably fasten the reaction unit onto it.

The reaction unit may also be advantageously provided with protrusions or grooves on its outer surface adapted to releasably engage with the grooves or protrusions of the internal surface of the susceptive casing through non-permanent mechanical interlocking or fastening mechanisms. Such mechanisms include, among others, any joints with releasable, i.e. non-permanent, interlocking shapes, such as any mechanism where a protruding part is adapted to latch on a corresponding indentation or hoop, and include hook and loop mechanisms, snap closures, etc.

The top wall and bottom wall of the reaction unit can be made of graphite, while the lateral walls, and/or the upstream and downstream sides in case they are only partially open, are made of graphite or silicon carbide.

Advantageously every wall of the reaction chamber can be made of graphite, but the inner surface of the reaction unit may be covered or coated, in toto or in part, with SiC, TaC or other materials, to protect graphite parts during deposition or during cleaning operations.

The reaction unit may further comprise a removable cover of a thermally insulating material situated over the downstream aperture and provided with at least one opening aligned in toto or in part with the downstream aperture and suitable to discharge a flow of exhaust gases. The cover's opening and the downstream aperture may be optionally additionally adapted to allow the insertion and withdrawal of a substrate holder. The removable cover may be further coupled to at least one of the four walls via releasable fastening means.

According to another embodiment, the reaction unit further comprises a first transition piece, optionally detachable, positioned over the upstream aperture adapted to be coupled with a precursor gas liner.

Most importantly, the reaction unit of the reaction chamber should further comprise engaging means, such as indentation, protrusions, hooks, loops, or slides, adapted to mechanically couple and cooperate with an end effector of an automated handling machine as described hereinafter, in order to be withdrawn/inserted from/into the susceptive casing in one piece and in an automated fashion. This allows to upgrade the removal of the reactor unit from manual to automated.

The reaction unit is compact and adapted to be handled. For instance, it may measure 200 - 400 mm times 30 - 50 mm in the transverse plane, and 200 - 500 mm in the longitudinal direction. The reaction unit may typically weight between 2-10 kg, preferably 2,5-6 kg. The susceptive casing may measure 200 - 500 mm in the longitudinal direction, and have a diameter, and/or its major length in the transverse direction of 210 - 450 mm.

According to first aspect, the present invention relates to an automated handling machine for handling a removable reaction unit of a reactor suitable for the epitaxial deposition of a semiconductor film on a substrate.

The automated handling machine is provided with a selective handling assembly comprising: (i) a first end effector adapted to mechanically couple with the removable reaction unit to displace it along a longitudinal direction (x) (and specifically to withdraw it from, or insert it in, the reactor); and (ii) a second end effector adapted to mechanically couple with a substrate holder to displace it along the longitudinal direction.

The selective handling assembly comprises at least a first actuator adapted to displace the first and second end effector in the longitudinal direction (x) from an extended position to a retreated position, and vice versa.

The second end effector is adapted to withdraw, or insert, the substrate holder from, or into, the removable reaction unit; whereas the first end effector is adapted to withdraw, or insert, the removable reaction unit from, or into, the reactor.

With the term "actuator" it is meant a part of a device or machine that allow it to achieve physical movements: it can be used to convert electrical, mechanical, gaseous or hydraulic inputs into a linear or a rotatory movement, or to a sequential combination of both

The above automated handling machine allows to automatically handle both a substrate holder and a removable reaction unit of a reaction chamber, thereby providing a unique compact solution that is space effective and does not require the presence of an operator in situ and/or manual intervention.

Under a first embodiment, in the automated handling machine according to the invention, the first and second end effectors are mutually mechanically constrained, so that when the first end effector is in an extended position, the second end effector is in a retreated position, and vice versa.

The embodiment above ensures that the handling of the substrate holder and of the reaction unit do not interfere with each other.

Under a second embodiment, in the automated handling machine according to the invention, the actuator is a step-by-step motor or servo- motor.

Furthermore, the selective handling assembly may advantageously, though not necessarily, comprise two pulleys operated by the actuator and coupled with a belt adapted to engage with, and displace, the first and second end effector.

The first and/or second end effector can be a gripper, such as: a rod, prong, fork, shovel or combinations thereof.

To withstand the weight of the reaction unit, the first end effector may be of a metallic or ceramic material, such as aluminum or silicon carbide, in oxide or nitride form, or titanium, stainless steel, and alloys thereof. The second end effector can be made of silicon carbide, borosilicate glass, sapphire glass, or quartz to avoid contamination of the substrate.

According to another embodiment, the automated handling machine according to the invention further comprises traction and pulling means coupled to the selective handling assembly. The traction and pulling means can be a linear motor, and in any case, they are adapted to displace the selective handling assembly along the longitudinal direction from a first handling position to at least a second handling position.

The first handling position is situated within the reactor and is suitable for the first or second end effectors of the selective handling assembly to engage with the reaction unit or the substrate holder. The second handling position is situated outside the reactor.

According to a further embodiment, the automated handling machine according to the invention additionally comprises motorized means coupled to the selective handling assembly and adapted to displace the latter along a vertical direction (z) (with the respect to the ground where the reactor is placed during operation).

The automated handling machine may preferably further comprise a screen having its major faces oriented in a plane perpendicular to the longitudinal direction and adapted to allow the first and second end effector to move in the longitudinal direction either through said faces or over any of their sides. When the first (or second) end effector is in the extended position, it protrudes from one of the maj or faces of the screen, whereas the actuator and the second (or first) end effector that is in retreated position are receded behind said face.

The screen, which can advantageously be made of quartz, shields the actuator from the heat of the reaction chamber and further improves the cleanliness of the same.

According to a second aspect, the present invention relates to the reaction chamber provided with the removable reaction unit hereinbefore described and suited for the epitaxial deposition of a semiconductor film on a substrate. It is here recalled that with the present new chamber design, the reaction chamber comprises an essentially hollow susceptive casing extending along the longitudinal direction (x) and featuring an internal surface and an external surface. It further comprises the removable reaction unit having an inner and outer surface and comprising: (i) four walls extending along the longitudinal direction, and (ii) an upstream and downstream side parallel to a transverse plane (yz) perpendicular to said longitudinal direction.

The four walls of the reaction unit comprise a bottom wall provided with a receiving area adapted to receive a substrate holder; the upstream side comprises an upstream aperture suited to receive a flow of carrier and precursor gases for the epitaxial deposition, and the downstream side comprises a downstream aperture suited to discharge a flow of exhaust gases.

The reaction unit is mechanically connected to the susceptive casing via releasable coupling means and is moveable relative to the susceptive casing in one piece.

The reaction unit is provided with engaging means, such as indentations or protrusions, adapted to cooperate with the first end effector of the automated handling machine according to any of the embodiments described above.

In the present invention, the reaction unit and the automated handling machine, specifically its selective handling assembly, can be advantageously designed to cooperate with each other, thorough the coupling of the engaging means of the reaction unit with the first end effector of the automated handling machine. Since the reaction unit is removable from its susceptive casing, the automated handling machine can easily release its releasable coupling means by exerting a force in the longitudinal direction or in the vertical direction (and optionally any other direction in the transverse plane). This allows to withdraw or insert the reaction unit from/into the reactor without difficulty, thereby facilitating and automating preventive maintenance operations.

According to a third aspect, the present invention relates to an assembly for displacing and handling a reaction unit for preventive reactor maintenance operations.

The assembly comprises: (i) a reactor, the automated handling machine according to any embodiment hereinbefore described, (ii) a transfer chamber, (iii) a unit handling chamber, and (iv) an optional load lock chamber, as described below.

The reactor of the assembly is suitable for the epitaxial deposition of a semiconductor film, preferably SiC or GaN, on a substrate. Preferably, it is a hot wall, crossflow reactor. It comprises a reaction chamber with a reaction unit removable in one piece from a susceptive casing, such as the removable reaction unit according to the present invention, equipped with means adapted to cooperate with the automated handling machine.

The reactor may advantageously comprise a thermal insulation system, featuring one or more thermally insulating components, and enclosing the reaction chamber. It may also include a liner suitable to direct process gases in the reaction unit and connected to the reaction unit with releasable coupling means.

The reactor may be protected by an outer enclosure, such a double wall quartz tube, which allows a cooling fluid flow in the interspace between its two walls. Other elements, which are typically used in reactors such as those hereinbefore described, can and should be present, as it is apparent to a person with average skill in the art.

One or more induction coils may be located outside the reactor in order to heat the susceptive casing and, directly or indirectly, the reaction unit of the reaction chamber.

The transfer chamber features a first aperture provided with a first gate valve adapted to receive or discharge the reaction unit from/to the reactor via one or more automated machines or via manual means; and a second aperture provided with a second gate valve.

The unit handling chamber is placed in communication with the transfer chamber through the second aperture and the second gate valve and is adapted to receive or discharge the reaction unit from/to the transfer chamber via motorized mechanical means.

The unit handling chamber is adapted to condition the reaction unit and is provided with a resealable access, such as a door, hatch, porthole, or valve, suitable for the extraction and insertion of the reaction unit by an operator or by automated handling means.

With the term "conditioning" it is meant a variety of operations, or cycles, suitable to prepare a reaction unit before insertion in the reactor. In addition, or in alternative, the operations or cycles are adapted to make the reaction unit suitable to be accessed by an operator or machine and extracted from the assembly for the removal or cleaning of parts. A possible cycle, before extraction of the reaction unit for cleaning, may comprise the step of creating a vacuum of less than 10 mbar, and to perform a refilling under an inert gas such as argon, nitrogen, helium, or xenon. In addition, or in alternative to the inert gas refilling, the reaction unit may undergo an inert gas purge, the inert gas of preference being argon.

An alternative cycle suited to be performed on a new/clean reaction unit before insertion in the reactor may comprise the steps of heating and vacuum degassing (the vacuum in this case should preferably be below 1 mbar, even more preferably below 10⁻³ mbar).

In the assembly according to the invention, the transfer chamber may be advantageously adapted to also receive or discharge through the first aperture a substrate holder from/to the reactor via motorized mechanical means. The assembly according to this embodiment may optionally and advantageously comprise a load lock chamber placed in communication with the transfer chamber through a third aperture and a third gate valve.

The load lock chamber can therefore receive or discharge the substrate holder from/to the transfer chamber via motorized mechanical means through the third aperture. The load lock chamber may additionally comprise a resealable access suitable for the extraction and insertion of the substrate holder by an operator or by automated handling means.

This embodiment advantageously provides an automatic handling of both the reaction unit and the substrates.

The presence of chambers that are put in communication with the reactor can avoid the exposure of the reaction unit to air during its extraction and insertion from/into the reactor, and the presence of automated handling means provides for a completely automated process that may reduce the downtime of the reactor of up to 70%.

### DESCRIPTION OF FIGURES

The illustrations presented herein are not meant to be actual views of any particular material, structure, or device, but are merely idealized representations that are used to describe embodiments of the disclosure. Specifically, they are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

Fig. 1 schematically illustrates, in two different settings depicted in panel I and II, a selective handling assembly (3010) of an automated handling machine according to an embodiment of the present invention.

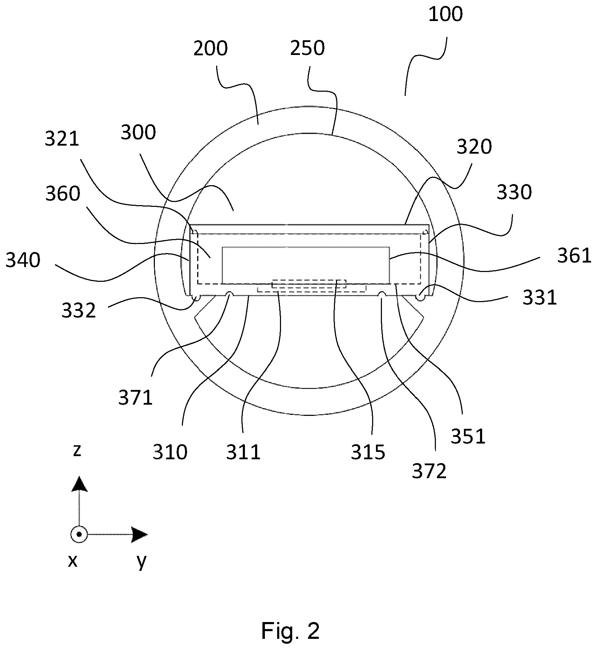

In both panels, the automated handling machine is adapted to handle a removable reaction unit of a reactor suitable for the epitaxial deposition of a semiconductor film on a substrate (typically placed on a substrate holder), such as the removable reaction unit of the reaction chamber depicted in Fig. 2.

The selective handling assembly (3010) comprises a first end effector (3100), comprising two stainless steel prongs, adapted to cooperate and mechanically couple with a removable reaction unit to displace it along a longitudinal direction (x). The first end effector is specifically adapted to withdraw, or insert, the removable reaction unit from, or into, the reactor

The selective handling assembly (3010) also comprises a second end effector (3200), comprising two quartz prongs, adapted to mechanically couple with a substrate holder to displace it along the longitudinal direction. The second end effector is specifically adapted to withdraw, or insert, the substrate holder from, or into, the removable reaction unit.

The selective handling assembly comprises at least a first actuator (not shown) adapted to displace the first and second end effector in the longitudinal direction (x) from an extended position to a retreated position, and vice versa. In particular, the first and second end effectors are mutually mechanically constrained, so that when the first end effector is in an extended position the second end effector is in a retreated position, and vice versa.

The first end effector is connected to a first sliding element (3150), which in turn is coupled to the actuator, through a pully and belt mechanism (not shown).

The second end effector is connected to a second sliding element (3250), which in turn is coupled to the actuator, through a pully and belt mechanism (not shown).

Panel I specifically shows the selective handling assembly hereinbefore described with the second end effector in an extended position, protruding from the screen (4000), through its major visible surface. Because the two end effectors are constrained with respect to each other, the first end effector is here in a retreated position behind the screen, as is the actuator.

Panel II shows the above selective handling assembly with the first end effector in an extended position, protruding from the major surface of the screen (4000), from under its bottom side. In this case, the second end effector is in a retreated position behind the screen, as is the actuator.

Fig. 2 schematically depicts a cross section in the transverse plane (yz) of an embodiment of the reaction chamber (100) of the present invention. The reaction chamber is suited for the epitaxial deposition of a semiconductor film on a substrate and comprises a hollow susceptive casing (200) and a reaction unit (300).

The susceptive casing extends along a longitudinal direction (x), perpendicular to the transverse plane. The susceptive casing features an internal surface (250) and an external surface, and contains the removable reaction unit (300).

The reaction unit (300) has a box-like shape. It comprises four walls (310, 320, 330, 340) extending along the longitudinal direction. The four walls include a top wall (320), two lateral walls (330, 340) and a bottom wall (310). The latter is provided with a receiving area (311) adapted to receive a substrate holder (315).

The reaction unit further comprises an upstream side (not shown) and a downstream side (360) parallel to a transverse plane (yz). In this embodiment, the downstream side is a wall provided with a downstream aperture (361) suited to receive a flow of carrier and precursor gases for the epitaxial deposition. The upstream side is completely open and corresponds to the upstream aperture indicate by a dashed line (351). The upstream aperture is suited to discharge a flow of exhaust gases. The reaction unit is mechanically connected to the susceptive casing via releasable coupling means (331, 332). It can be moveable relative to the susceptive casing in one piece, thereby facilitating its insertion and withdrawal from/to the susceptive casing, and reducing the time required for preventive maintenance operations.

To further facilitate preventive maintenance operations, the top wall (320) is connected to the two lateral walls and to the upstream and downstream sides via releasable coupling means (321), such as female-male interlocking mechanisms.

The handling of the reaction unit can be facilitated and automated by providing it with engaging means, such as indentations (371, 372), adapted to couple with the first end effector of the automated handling machine according to the invention, such as the one partially depicted in Fig. 1. In this case, the first end effector may have a fork-like shape provided with two prongs adapted to couple with the indentations (371, 372).

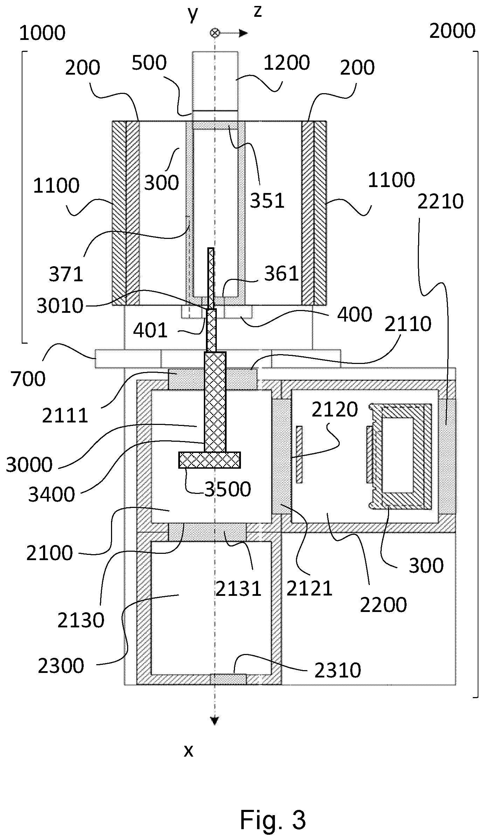

Fig. 3 shows a simplified schematic view of an assembly (2000) according to an embodiment of the invention. The assembly is designed to facilitate the displacement and handling of a reaction unit, for preventive reactor maintenance operations. The assembly comprises: (i) a reactor (1000), (ii) a system of connected chambers (2100, 2200, 2300) coupled to the reactor; and (iii) an automated handling machine (3000) comprising the selective handling assembly (3010) of Fig. 1.

The automated handling machine, hereby simplified in its main functional building blocks (identifiable by a net-like pattern), further comprises traction and pulling means (3400) coupled to the selective handling assembly and adapted to displace it along a longitudinal direction from a first handling position inside the reactor to at least a second handling position outside the reactor, preferably in correspondence of the transfer chamber (2100). The traction and pulling means may be a magnetic motor.

The automated handling machine further comprises vertical motorized means (3500) coupled to the selective handling assembly. In general, the coupling between the vertical motorized means and the selective handling assembly may be either direct or indirect, for instance the coupling may take place via the traction and pulling means, as depicted in the present figure.

The automated handling machine may extend within the transfer chamber, or it can be placed outside said chamber, but still within an enclosure to avoid the exposure of its load to air. It can in all instances coordinate with further motorized means within said transfer chamber to transfer the reaction unit and/or the substrate holder to/from the transfer chamber from/to the reactor.

In this figure, the automated handling machine is in a setting with the second end effector in the extended position, i.e. placed within the reactor and inside the reaction unit respectively through the aperture in the downstream drum (700) and the reaction unit apertures (401, 361). In this position, the second end effector may engage with a substrate holder to displace it.

The reactor comprises a double wall quartz tube and is wrapped by a coil for induction heating (not shown). The reactor further comprises a thermal insulation system (1100) wrapped around the reaction chamber. The latter includes a susceptive casing (200) and a reaction unit (300).

The reaction unit features a first transition piece (500) positioned over the upstream aperture (351) and coupled to a liner (1200). The reaction unit further comprises a removable cover (400) of a thermally insulating material situated over the downstream side (360) and provided with one opening (401) aligned with the downstream aperture (361). The reaction unit is equipped with engaging means (371, 372), adapted to couple with the first end effector of the selective handling assembly (3010) of the automated handling machine (3000).

The reactor can be connected to the system of connected chambers (2100, 2200, 2300) via a downstream drum (700) provide with an aperture and resealing means, such as a porthole, door, or valve.

The system of chambers comprises a transfer chamber (2100) having a first aperture (2110) provided with a first gate valve (2111) and adapted to receive or discharge the reaction unit from/to the reactor through the downstream drum via one or more automated machines (or, less preferably, via manual means). The transfer chamber also features a second aperture (2120) provided with a second gate valve (2121).

The system of connected chambers (2100, 2200, 2300) also comprises a unit handling chamber (2200) placed in communication with the transfer chamber through the second aperture (2120) and the second gate valve (2121). The unit handling chamber is adapted to receive or discharge the reaction unit from/to the transfer chamber via motorized mechanical means and is provided with a resealable access (2210) suitable for the extraction and insertion of the reaction unit (300) by an operator or by automated handling means.

The unit handling chamber may be used to condition the reaction unit, before its withdrawal from the assembly, or prior to its insertion in the reactor through the transfer chamber.

The system of connected chambers (2100, 2200, 2300) also comprises a load lock chamber (2300) placed in communication with the transfer chamber through a third aperture (2130) and a third gate valve (2131). The load lock chamber is adapted to receive or discharge the substrate holder from/to the transfer chamber through the third aperture, via motorized mechanical means (not shown).

Advantageously, the assembly according to the present embodiment is equipped with the automated handling machine (3000) provided with a first end effector suitable to engage with the reaction unit to withdraw it from the susceptive casing and insert it in the transfer chamber, and vice versa.

The automated handling machine is also provided with a second end effector suitable to engage with a substrate holder to insert or withdraw it to/from the reaction unit, thereby providing for a completely automated system

The subject matter of the present disclosure includes all novel and nonobvious combinations and sub-combinations of the various processes, systems, and configurations, and other features, functions, acts, and/or properties disclosed herein, as well as any and all equivalents thereof.

In the description and the claims in this application the words "comprise" and its variations such as "comprising" and "comprises" do not rule out the presence of other additional elements, components, or stages.

The discussion of documents, deeds, materials, apparatus, articles and the like is included in the text solely for the purpose of providing context for this invention; it should not however be understood that this material or part thereof constitutes general knowledge in the field relating to the invention prior to the priority date of each of the claims appended to this application.

## Claims

1. An automated handling machine (3000) for handling a removable reaction unit of a reactor suitable for the epitaxial deposition of a semiconductor film on a substrate, **characterized in that** it is provided with a selective handling assembly (3010) comprising:
- a first end effector (3100) adapted to mechanically couple with the removable reaction unit to displace it along a longitudinal direction (x);
- a second end effector (3200) adapted to mechanically couple with a substrate holder to displace it along the longitudinal direction;
wherein the selective handling assembly comprises at least a first actuator (3300) adapted to displace the first and second end effector in a longitudinal direction from an extended position to a retreated position, and vice versa; the second end effector being adapted to withdraw, or insert, the substrate holder from, or into, the removable reaction unit; and the first end effector being adapted to withdraw, or insert, the removable reaction unit from, or into, the reactor.

2. The automated handling machine according to claim 1, where the first and second end effectors are mutually mechanically constrained, so that when the first end effector is in an extended position the second end effector is in a retreated position, and vice versa.

3. The automated handling machine according to any of the preceding claims, wherein the actuator is a step-by-step motor or servo- motor.

4. The automated handling machine according to any of the preceding claims, where the selective handling assembly comprises two pulleys operated by the actuator and coupled with a belt adapted to engage with, and displace, the first and second end effector.

5. The automated handling machine according to any of the preceding claims, wherein the first and/or second end effector is a gripper.

6. The automated handling machine according to claim 5, where the gripper is chosen from the group consisting of one or more of the following elements: rod, prong, fork, shovel, and combinations thereof.

7. The automated handling machine according to any of the preceding claims, wherein the first end effector is made of a metallic or ceramic material and the second end effector is made of silicon carbide, borosilicate glass, sapphire glass or quartz.

8. The automated handling machine according claim 7, wherein the first end effector is made of aluminum or silicon carbide, in oxide or nitride form, or titanium, stainless steel, and alloys thereof.

9. The automated handling machine according to any of the preceding claims, further comprising traction and pulling means (3400) coupled to the selective handling assembly and adapted to displace it along a longitudinal direction from a first handling position to at least a second handling position.

10. The automated handling machine according to claim 9, wherein the traction and pulling means comprise a linear motor.

11. The automated handling machine according to any of the preceding claims, further comprising vertical motorized means (3500) coupled to the selective handling assembly and adapted to displace the latter along a vertical direction (z).

12. The automated handling machine according to any of the preceding claims, further comprising a screen (4000) having a major surface oriented in a transvers plane (yz) perpendicular to the longitudinal direction; the screen being adapted to allow both the first and second end effector to move in the longitudinal direction either through said major surface or over any its borders; the screen being positioned so that the first or second end effector that is in the extended position protrudes from said major surface, whereas the first or second end effector in retreated position, and the actuator, are receded behind said major surface.

13. The automated handling machine according to claim 12 wherein the screen is made of quartz.

14. A reaction chamber (100) for the epitaxial deposition of a semiconductor film on a substrate, comprising:
- An essentially hollow susceptive casing (200) extending along a longitudinal direction (x) and featuring an internal surface (250) and an external surface; and
- a removable reaction unit (300) having an inner and outer surface and comprising: (i) four walls (310, 320, 330, 340) extending along the longitudinal direction, and (ii) an upstream and downstream side (350, 360) parallel to a transverse plane (yz) perpendicular to said longitudinal direction;
wherein the four walls of the reaction unit comprise a bottom wall (310) provided with a receiving area (311) adapted to receive a substrate holder; the upstream side comprises an upstream aperture (351) suited to receive a flow of carrier and precursor gases for the epitaxial deposition, and the downstream side comprises a downstream aperture (361) suited to discharge a flow of exhaust gases; the reaction unit being mechanically connected to the susceptive casing via releasable coupling means (331, 332) and being moveable relative to the susceptive casing in one piece; the reaction unit being provided with engaging means (371, 372) adapted to co-operate with the first end effector of the automated handling machine according to any one of claims 1-13.

15. An assembly (2000) for displacing and handling a reaction unit for preventive reactor maintenance operations comprising:
- a reactor (1000) for the epitaxial deposition of a semiconductor film on a substrate and comprising a reaction chamber (100) having a reaction unit (300) removable in one piece from a susceptive casing (200);
- an automated handling machine according to any one of claims 1-13;
- a transfer chamber (2100) comprising a first aperture (2110) provided with a first gate valve (2111) adapted to receive or discharge the reaction unit from/to the reactor via the automated handling machine; and a second aperture (2120) provided with a second gate valve (2121); and
- a unit handling chamber (2200) placed in communication with the transfer chamber through the second aperture (2120) and the second gate valve (2121), and adapted to receive or discharge the reaction unit from/to the transfer chamber via motorized mechanical means;
wherein the unit handling chamber is adapted to condition the reaction unit and is provided with a resealable access (2210) suitable for the extraction and insertion of the reaction unit by an operator or by automated handling means.

16. The assembly according to claim 17 wherein the transfer chamber is additionally adapted to receive or discharge through the first aperture a substrate holder from/to the reactor via the automated handling machine and additional optional motorized mechanical means; the assembly further comprising a load lock chamber (2300) placed in communication with the transfer chamber through a third aperture (2130) and a third gate valve (2131); the load lock chamber being adapted to receive or discharge the substrate holder from/to the transfer chamber via motorized mechanical means through said third aperture.

## Patentansprüche

1. Automatisierte Handhabungsmaschine (3000) zur Handhabung einer abnehmbaren Reaktionseinheit eines Reaktors, der zur epitaktischen Abscheidung eines Halbleiterfilms auf einem Substrat geeignet ist, **dadurch gekennzeichnet, dass** sie mit einer selektiven Handhabungsbaugruppe (3010) versehen ist, umfassend:
einen ersten Endeffektor (3100), der eingerichtet ist, mit der abnehmbaren Reaktionseinheit mechanisch zu koppeln, um diese entlang einer Längsrichtung (x) zu verschieben;
einen zweiten Endeffektor (3200), der eingerichtet ist, mit einem Substrathalter mechanisch zu koppeln, um diesen entlang der Längsrichtung zu verschieben;
wobei die selektive Handhabungsbaugruppe mindestens einen ersten Aktuator (3300) umfasst, der eingerichtet ist, den ersten und zweiten Endeffektor in eine Längsrichtung von einer ausgefahrenen Position in eine eingefahrene Position zu verschieben und umgekehrt; wobei der zweite Endeffektor eingerichtet ist, den Substrathalter aus der abnehmbaren Reaktionseinheit zu entnehmen oder in diese einzuführen; und der erste Endeffektor eingerichtet ist, die abnehmbare Reaktionseinheit aus dem Reaktor zu entnehmen oder in diesen einzuführen.

2. Automatisierte Handhabungsmaschine nach Anspruch 1, wobei der erste und der zweite Endeffektor mechanisch miteinander befestigt werden, sodass, wenn sich der erste Endeffektor in einer ausgefahrenen Position befindet, sich der zweite Endeffektor in einer eingefahrenen Position befindet und umgekehrt.

3. Automatisierte Handhabungsmaschine nach einem der vorhergehenden Ansprüche, wobei der Aktuator ein Schrittmotor oder Servomotor ist.

4. Automatisierte Handhabungsmaschine nach einem der vorhergehenden Ansprüche, wobei die selektive Handhabungsbaugruppe zwei Rollen umfasst, die durch den Aktuator angetrieben werden und die mit einem Riemen gekoppelt sind, der eingerichtet ist, mit dem ersten und zweiten Endeffektor in Eingriff zu treten und diese zu verschieben.

5. Automatisierte Handhabungsmaschine nach einem der vorhergehenden Ansprüche, wobei der erste und/oder der zweite Endeffektor ein Greifer ist.

6. Automatisierte Handhabungsmaschine nach Anspruch 5, wobei der Greifer aus der Gruppe bestehend aus einem oder mehreren der folgenden: Stange, Zinke, Gabel, Schaufel und deren Kombinationen ausgewählt wird.

7. Automatisierte Handhabungsmaschine nach einem der vorhergehenden Ansprüche, wobei der erste Endeffektor aus einem metallischen oder keramischen Material hergestellt wird und der zweite Endeffektor aus Siliciumcarbid, Borosilikatglas, Saphirglas oder Quarz hergestellt wird.

8. Automatisierte Handhabungsmaschine nach Anspruch 7, wobei der erste Endeffektor aus Aluminium oder Siliciumcarbid in Oxid- oder Nitridform oder aus Titan, rostfreiem Stahl und deren Legierungen hergestellt wird.

9. Automatisierte Handhabungsmaschine nach einem der vorhergehenden Ansprüche, ferner umfassend Zug- und Schubmittel (3400), die mit der selektiven Handhabungsgruppe gekoppelt sind und eingerichtet sind, diese entlang einer Längsrichtung von einer ersten Handhabungsposition zu mindestens einer zweiten Handhabungsposition zu verschieben.

10. Automatisierte Handhabungsmaschine nach Anspruch 9, wobei die Zug- und Schubmittel einen Linearmotor umfassen.

11. Automatisierte Handhabungsmaschine nach einem der vorhergehenden Ansprüche, ferner umfassend vertikale motorisierte Mittel (3500), die mit der selektiven Handhabungsgruppe gekoppelt sind und eingerichtet sind, die letztere in vertikaler Richtung (z) zu verschieben.

12. Automatisierte Handhabungsmaschine nach einem der vorhergehenden Ansprüche, ferner umfassend einen Schirm (4000) aufweisend eine Hauptfläche, die in einer Querebene (yz) orientiert ist, die senkrecht zu der Längsrichtung ist; wobei der Schirm eingerichtet ist, sowohl dem ersten als auch dem zweiten Endeffektor zu ermöglichen, in eine Längsrichtung entweder durch die Hauptfläche oder über einen ihrer Ränder zu bewegen; wobei der Schirm positioniert ist, sodass der erste oder der zweite Endeffektor, der sich in der ausgefahrenen Position befindet, über die Hauptfläche vorsteht, während der erste oder der zweite Endeffektor, der sich in der eingefahrenen Position befindet und der Aktuator hinter dieser Hauptfläche zurückgetreten werden.

13. Automatisierte Handhabungsmaschine nach Anspruch 12, wobei der Schirm aus Quarz besteht.

14. Reaktionskammer (100) zur epitaktischen Abscheidung eines Halbleiterfilms auf einem Substrat, umfassend:
- ein im Wesentlichen hohles, empfängliches Gehäuse (200), das sich entlang einer Längsrichtung (x) erstreckt und eine innere Oberfläche (250) und eine äußere Oberfläche aufweist; und
- eine abnehmbare Reaktionseinheit (300) aufweisend eine innere und eine äußere Oberfläche und umfassend: (i) vier Wände (310, 320, 330, 340), die sich entlang der Längsrichtung erstrecken, und (ii) eine stromaufwärts liegende Seite und eine stromabwärts liegende Seite (350, 360), die parallel zu einer Querebene (yz) sind, die senkrecht zu der Längsrichtung ist;
wobei die vier Wände der Reaktionseinheit eine Bodenwand (310) umfassen, die mit einem Aufnahmeraum (311) versehen ist, der eingerichtet ist, einen Substrathalter aufzunehmen; die stromaufwärts liegende Seite eine stromaufwärts liegende Öffnung (351) umfasst, die geeignet ist, einen Strom von Träger-und Präkursorgases für die epitaktische Abscheidung zu empfangen, und die stromabwärts liegene Seite eine stromabwärts liegende Öffnung (361) umfasst, die geeignet ist, einen Strom von Abgases abzuführen; wobei die Reaktionseinheit über lösbare Kupplungsmittel (331, 332) mechanisch mit dem empfänglichen Gehäuse verbunden ist und in Bezug auf das empfängliche Gehäuse einstückig beweglich ist; wobei die Reaktionseinheit mit Eingriffsmitteln (371, 372) versehen ist, die eingerichtet sind, mit dem ersten Endeffektor der automatisierten Handhabungsmaschine nach einem der Ansprüche 1-13 zusammenzuwirken.

15. Baugruppe (2000) zur Verschiebung und Handhabung einer Reaktionseinheit für präventive Wartungsarbeiten an dem Reaktor, umfassend:
- einen Reaktor (1000) zur epitaktischen Abscheidung eines Halbleiterfilms auf einem Substrat und umfassend eine Reaktionskammer (100) aufweisend eine Reaktionseinheit (300), die einstückig von einem empfänglichen Gehäuse (200) abnehmbar ist;
- eine automatisierte Handhabungsmaschine nach einem der Ansprüche 1 bis 13;
- eine Transferkammer (2100), umfassend eine erste Öffnung (2110), die mit einem ersten Absperrventil (2111) versehen ist, die eingerichtet ist, die Reaktionseinheit von dem/zu dem Reaktor über die automatisierte Handhabungsmaschine aufzunehmen oder abzuführen; und eine zweite Öffnung (2120), die mit einem zweiten Absperrventil (2121) versehen ist; und
- eine Einheit-Handhabungskammer (2200), die über die zweite Öffnung (2120) und das zweite Absperrventil (2121) mit der Transferkammer in Kommunikation gebracht wird und eingerichtet ist, die Reaktionseinheit über motorisierte mechanische Mittel von der/zu der Transferkammer aufzunehmen oder abzuführen;
wobei die Einheit-Handhabungskammer eingerichtet ist, die Reaktionseinheit zu konditionieren, und mit einem wiederverschließbaren Zugang (2210) versehen ist, der zur Entnahme und zum Einsetzen der Reaktionseinheit durch einen Bediener oder durch automatisierte Handhabungsmittel geeignet ist.

16. Anordnung nach Anspruch 17, wobei die Transferkammer zusätzlich eingerichtet ist, über die erste Öffnung einen Substrathalter von dem/zu dem Reaktor über die automatisierte Handhabungsmaschine und zusätzliche optionale motorisierte mechanische Mittel aufzunehmen oder abzuführen; wobei die Baugruppe ferner eine Lastblockierungskammer (2300) umfasst, die über eine dritte Öffnung (2130) und ein drittes Absperrventil (2131) mit der Transferkammer in Kommunikation gebracht wird; wobei die Lastblockierungskammer eingerichtet ist, den Substrathalter über die dritte Öffnung über motorisierte mechanische Mittel von der/zu derTransferkammer aufzunehmen oder abzuführen.

## Revendications

1. Machine de manutention automatisée (3000) pour la manutention d'une unité de réaction amovible d'un réacteur apte au dépôt épitaxial d'un film semi-conducteur sur un substrat, **caractérisée en ce qu'**elle est pourvue d'un ensemble de manutention sélective (3010) comprenant :
un premier effecteur terminal (3100) apte à s'accoupler mécaniquement avec l'unité de réaction amovible pour la déplacer selon une direction longitudinale (x) ;
un second effecteur terminal (3200) apte à s'accoupler mécaniquement avec un support de substrat pour le déplacer selon la direction longitudinale ;
lequel ensemble de manutention sélective comprend au moins un premier actionneur (3300) apte à déplacer le premier et le second effecteur terminal dans une direction longitudinale d'une position étendue à une position rétractée, et vice versa ; le second effecteur terminal étant apte à extraire ou insérer le support de substrat depuis ou dans l'unité de réaction amovible ; et le premier effecteur terminal étant apte à extraire ou insérer l'unité de réaction amovible depuis ou dans le réacteur.

2. Machine de manutention automatisée selon la revendication 1, dans laquelle les premier et second effecteurs terminaux sont mécaniquement contraints l'un à l'autre, de sorte que lorsque le premier effecteur terminal est dans une position étendue, le second effecteur terminal est dans une position rétractée, et vice versa.

3. Machine de manutention automatisée selon l'une quelconque des revendications précédentes, dans laquelle l'actionneur est un moteur pas à pas ou un servomoteur.

4. Machine de manutention automatisée selon l'une quelconque des revendications précédentes, dans laquelle l'ensemble de manutention sélective comprend deux poulies actionnées par l'actionneur et couplées à une courroie apte à s'engager avec, et déplacer, les premier et second effecteurs terminaux.

5. Machine de manutention automatisée selon l'une quelconque des revendications précédentes, dans laquelle le premier et/ou le second effecteur terminal est une pince.

6. Machine de manutention automatisée selon la revendication 5, dans laquelle la pince est choisie dans le groupe constitué d'un ou plusieurs des éléments suivants : tige, dent, fourche, pelle, et leurs combinaisons.

7. Machine de manutention automatisée selon l'une quelconque des revendications précédentes, dans laquelle le premier effecteur terminal est constitué d'un matériau métallique ou céramique et le second effecteur terminal est constitué de carbure de silicium, verre borosilicaté, verre saphir ou quartz.

8. Machine de manutention automatisée selon la revendication 7, dans laquelle le premier effecteur terminal est constitué d'aluminium ou de carbure de silicium, sous forme d'oxyde ou de nitrure, ou de titane, acier inoxydable et leurs alliages.

9. Machine de manutention automatisée selon l'une quelconque des revendications précédentes, comprenant en outre des moyens de traction et de poussée (3400) couplés à l'ensemble de manutention sélective et aptes à le déplacer selon une direction longitudinale d'une première position de manutention à au moins une seconde position de manutention.

10. Machine de manutention automatisée selon la revendication 9, dans laquelle les moyens de traction et de poussée comprennent un moteur linéaire.

11. Machine de manutention automatisée selon l'une quelconque des revendications précédentes, comprenant en outre des moyens motorisés verticaux (3500) couplés à l'ensemble de manutention sélective et aptes à déplacer ce dernier selon une direction verticale (z).

12. Machine de manutention automatisée selon l'une quelconque des revendications précédentes, comprenant en outre un écran (4000) ayant une surface principale orientée dans un plan transversal (yz) perpendiculaire à la direction longitudinale ; l'écran étant apte à permettre à la fois au premier et au second effecteur terminal de se déplacer dans la direction longitudinale soit à travers ladite surface principale soit au-dessus de l'un quelconque de ses bords ; l'écran étant positionné de sorte que l'effecteur terminal, premier ou second, qui est en position étendue, dépasse ladite surface principale, tandis que l'effecteur terminal, premier ou second, en position rétractée, ainsi que l'actionneur, sont reculés derrière ladite surface principale.

13. Machine de manutention automatisée selon la revendication 12, dans laquelle l'écran est constitué de quartz.

14. Chambre de réaction (100) pour le dépôt épitaxial d'un film semi-conducteur sur un substrat, comprenant :
une enceinte susceptible essentiellement creuse (200) s'étendant selon une direction longitudinale (x) et présentant une surface interne (250) et une surface externe ; et
une unité de réaction amovible (300) présentant une surface interne et une surface externe et comprenant : (i) quatre parois (310, 320, 330, 340) s'étendant selon la direction longitudinale, et (ii) un côté amont et un côté aval (350, 360) parallèles à un plan transversal (yz) perpendiculaire à ladite direction longitudinale ;
dans laquelle les quatre parois de l'unité de réaction comprennent une paroi inférieure (310) pourvue d'une zone de réception (311) apte à recevoir un support de substrat ; le côté amont comprend une ouverture amont (351) apte à recevoir un flux de gaz vecteurs et précurseurs pour le dépôt épitaxial, et le côté aval comprend une ouverture aval (361) apte à évacuer un flux de gaz d'échappement ; l'unité de réaction étant mécaniquement reliée à l'enceinte susceptible par des moyens de couplage amovibles (331, 332) et étant mobile par rapport à l'enceinte susceptible en un seul tenant ; l'unité de réaction étant pourvue de moyens d'accouplement (371, 372) aptes à coopérer avec le premier effecteur terminal de la machine de manutention automatisée selon l'une quelconque des revendications 1 à 13.

15. Ensemble (2000) pour le déplacement et la manutention d'une unité de réaction à des fins d'opérations de maintenance préventive du réacteur comprenant :
un réacteur (1000) pour le dépôt épitaxial d'un film semi-conducteur sur un substrat et comprenant une chambre de réaction (100) ayant une unité de réaction (300) amovible en un seul tenant d'une enceinte susceptible (200) ;
une machine de manutention automatisée selon l'une quelconque des revendications 1 à 13 ;
une chambre de transfert (2100) comprenant une première ouverture (2110) pourvue d'un premier clapet (2111) apte à recevoir ou à évacuer l'unité de réaction vers/depuis le réacteur via la machine de manutention automatisée ; et une seconde ouverture (2120) pourvue d'un second clapet (2121) ; et
une chambre de traitement de l'unité (2200) mise en communication avec la chambre de transfert via la seconde ouverture (2120) et le second clapet (2121), et apte à recevoir ou à évacuer l'unité de réaction vers/depuis la chambre de transfert via des moyens mécaniques motorisés ;
dans laquelle la chambre de traitement de l'unité est apte à conditionner l'unité de réaction et est pourvue d'un accès refermable (2210) apte à l'extraction et à l'insertion de l'unité de réaction par un opérateur ou par des moyens de manutention automatisés.

16. Ensemble selon la revendication 17, dans lequel la chambre de transfert est en outre apte à recevoir ou à évacuer, par la première ouverture, un support de substrat vers/depuis le réacteur via la machine de manutention automatisée et des moyens mécaniques motorisés optionnels supplémentaires ; l'ensemble comprenant en outre une chambre de sas de chargement (2300) mise en communication avec la chambre de transfert via une troisième ouverture (2130) et un troisième clapet (2131) ; la chambre de sas de chargement étant apte à recevoir ou à évacuer le support de substrat vers/depuis la chambre de transfert via des moyens mécaniques motorisés par ladite troisième ouverture.
